# EUROPÄISCHE PATENTSCHRIFT

(11) **EP 3 186 128 B1**
(45) Veröffentlichungstag und Bekanntmachung des Hinweises auf die Patenterteilung: **13.06.2018**
(21) Anmeldenummer: 15771856.0
(22) Anmeldetag: 24.08.2015
(51) Int. Cl.: B61K 9/12, G01M 17/10, G01B 11/02

(54) **VORRICHTUNG UND VERFAHREN ZUR ERMITTLUNG VON GEOMETRIE-KENNWERTEN EINES RADPROFILS AN EINEM ROLLENDEN RAD EINES SCHIENENFAHRZEUGS**
DEVICE AND METHOD FOR DETERMINING GEOMETRY CHARACTERISTIC VALUES OF A WHEEL PROFILE ON A ROLLING WHEEL OF A RAIL VEHICLE
DISPOSITIF ET PROCÉDÉ POUR LA DÉTERMINATION DE CARACTÉRISTIQUES GÉOMÉTRIQUES D'UN PROFIL DE ROUE SUR UNE ROUE QUI TOURNE D'UN VÉHICULE FERROVIAIRE

(30) Priorität: 29.08.2014 DE 102014012564
(43) Veröffentlichungstag der Anmeldung: 05.07.2017
(73) Patentinhaber: Schenck Process Europe GmbH, 64293 Darmstadt (DE)
(72) Erfinder: EHMKE, Fritz, 64397 Modautal-Lützelbach (DE); RAIS, Viktor, 64397 Modaultal (DE)
(86) Internationale Anmeldenummer: PCT/EP2015/001723
(87) Internationale Veröffentlichungsnummer: WO 2016/030009

(56) Entgegenhaltungen:
- WO-A1-92/00214
- DE-A1- 10 313 191
- FR-A1- 2 805 038
- US-A1- 2003 072 001
- US-A1- 2003 160 193

## Beschreibung

Die vorliegende Erfindung betrifft eine Vorrichtung zur Ermittlung von Geometrie-Kennwerten eines Radprofils an einem rollenden Rad eines Schienenfahrzeugs gemäß dem Oberbegriff des Patentanspruchs 1 und ein Verfahren zur Vermessung eines Radprofils gemäß Patentanspruch 10.

Das Fahrverhalten von Schienenfahrzeugen und deren Sicherheit wird wesentlich durch die Geometrie des Rad-Schiene-Kontakts bestimmt. Gleichzeitig wird dadurch auch der Verschleiß der Räder und der Schiene beeinflusst, wobei der Verschleiß wesentlich von der Gleislage, Kurven und dem Laufverhalten der Waggons in Querrichtung (Sinuslauf) abhängig ist.

Für die Geometrie-Kennwerte sind gesetzlich Grenzwerte, also Mindest- und Höchstmaße festgelegt, die bei Betrieb von Schienenfahrzeuge einzuhalten sind. Daher sind die Betreiber von Schienenfahrzeugen dazu verpflichtet, diese Grenzwerte einzuhalten und die Geometrie-Kennwerte der Räder der Schienenfahrzeuge in entsprechenden Abständen zu überprüfen.

Neben der Zustandsüberwachung der Räder im Stand bzw. in Instandsetzungswerken, wobei die Räder mittels Messlehren manuell abgetastet werden, sind Verfahren und Vorrichtungen bekannt, bei denen die Geometrie des Rades während der Fahrt erfasst werden soll.

Beispielsweise offenbart die DE 10 2004 033 432 A1 eine Vorrichtung zur Messung von Zustandsdaten an einem rollenden Radsatz bei der ein berührungslos messender Entfernungssensor im Schienenkopf und weitere Entfernungssensoren horizontal entlang der Schiene angeordnet sind, und über die ermittelten Abstände der Axialversatz eines vorbeirollenden Rades oder Radsatzes ermittelt wird. Bei dieser Lösung müssen allerdings Veränderungen an der Fahrschiene vorgenommen werden, was einerseits aufwändig ist und andererseits zu einer Beschränkung der Überfahrgeschwindigkeit führen kann.

Aus der US 5 577 690 A ist eine Vorrichtung zur Vermessung des Spurkranzes eines Rades mittels Mikrowellen bekannt, bei der eine Sender-Empfänger-Einheit neben der Schiene unterhalb des Spurkranzes angeordnet ist. Die Mikrowellen werden vom Sender in vertikaler Richtung nach oben auf die Oberfläche des Spurkranzes gesendet und vom Spurkranz zurück auf den Empfänger reflektiert. Damit soll indirekt die Spurkranzhöhe und damit die Abnutzung der Lauffläche ermittelt werden. Nachteilig an dieser Anordnung ist jedoch, dass die Messergebnisse fehleranfällig sind, das der Sinuslauf des schienengebundenen Fahrzeuges nicht berücksichtigt werden kann.

Weiterhin sind lasergestützte Überfahrmesseinrichtungen zur Erfassung des Radprofils von schienengebundenen Fahrzeugen-bekannt. Die Sensoren sind zum Schutz vor Umwelteinflüssen in einem geschlossenen Gehäuse angeordnet. Eine vorhandene Öffnungsklappe oder ein Schieber an dem Schutzgehäuse muss kurz vor Einfahren des Zuges über der Messanlage geöffnet werden, um die Messung möglich zu machen. Außerdem ist aus der US 5 636 026 A ein lasergestütztes Verfahren zur Bestimmung von Radgeometrie-Kennwerten bekannt, bei dem ein Laserstrahl auf einen Punkt eines Radprofils gerichtet wird und dessen Reflektion detektiert wird, um die detektierten Signale anschließend mit gespeicherten Signalen eines unversehrten Rades zu vergleichen.

Nachteilig an Lasermessverfahren ist jedoch, dass diese bei Regen, Schnee, Licht- und Schattenwechsel, direkter Sonneneinstrahlung und Staub fehleranfällig sind und daher verfälschte oder ungenaue Messergebnisse liefern können. Weitere relevante Offenbarungen von Vorrichtungen bzw. Verfahren zur Ermittlung von Geometrie-Kennwerte eines Radprofils werden in den DE 103 13 191 A1 und US 2003/072001 A1 veröffentlicht.

Aufgabe der vorliegenden Erfindung ist daher, die geometrischen Kennwerte eines rollenden Rades eines schienengebundenen Fahrzeugs während der Fahrt und dessen Verschleißzustand zuverlässig zu bestimmen.

Diese Aufgabe wird durch eine Vorrichtung mit den Merkmalen des Patentanspruchs 1 und ein Verfahren gemäß Patentanspruch 10 gelöst. Vorteilhafte Weiterbildungen sind Gegenstand der abhängigen Ansprüche und in der Beschreibung enthalten.

Mit der Erfindung wird eine Vorrichtung zur Ermittlung von Geometrie-Kennwerten eines Radprofils an einem rollenden Rad eines Schienenfahrzeugs mit mindestens einem berührungslos messenden Entfernungssensor, der mit Abstand a zur Schiene angeordnet ist, einer elektronischen Auswertevorrichtung zur Berechnung der Geometrie-Kennwerte aus den erfassten Abstandssignalen und einer Anzeigeeinheit bereitgestellt. Bei der erfindungsgemäßen Vorrichtung ist der erste berührungslos messende Entfernungssensor in Form eines FMCW-Radarsensors zur Erfassung der Geometrie-Kennwerte, vorzugsweise orthogonal auf eine Referenzfläche am rollenden Rad und wenigstens ein weiterer berührungslos messender Entfernungssensor in Form eines FMCW-Radarsensors unter einem definiertem Einfallswinkel auf die der Schiene zugewandten bzw. zu untersuchenden Radfläche des rollenden Rades gerichtet.

Ein frequenzmodulierter Dauerstrichradar bzw. FMCW-Radar ist ein Radarsystem, das sich von einem Impulsradar dadurch unterscheidet, dass der Sender eines Dauerstrichradars während der Dauer des Messvorganges ununterbrochen arbeitet. Frequenzmodulierte Dauerstrichradare arbeiten dabei oft mit einer periodischen Frequenzmodulation, die für einen hohen Anspruch an eine Genauigkeit der Messung möglichst zeitlinear sein muss.

Dies bedeutet, dass das Empfangssignal gegenüber dem Sendesignal jeweils um die Laufzeit 2r/c verzögert ist. Während der Zeit Δt = 2r/c, die das ausgesendete Dauerstrichradarsignal benötigt, um mit Lichtgeschwindigkeit c die Entfernung r zum reflektierenden Objekt hin und zurück zu durchlaufen, hat sich die Frequenz des Radarsenders geändert. Der Betrag der Frequenzdifferenz ist dementsprechend ein Maß für die Laufzeit und Entfernung der Sender-/Empfängereinheit und dem Referenzpunkt bzw. Zielobjekt.

Je schneller die Frequenz verändert wird, je größer also die Steilheit der Frequenzänderung df/dt, umso größer ist die Frequenzdifferenz für eine gegebene Zeitdifferenz, wodurch sich das Entfernungsauflösungsvermögen des Dauerstrichradars bzw. FMCW-Radars verbessert.

Dementsprechend ist bei linearer Frequenzmodulation insofern die Dopplerfrequenz ignoriert werden kann, der Betrag des Frequenzabstandes Δf zwischen Sende- und Empfangssignal zu jedem Zeitpunkt ein Maß für die Laufzeit Δt und somit für die Entfernung des Referenzpunktes bzw. des Zielobjektes von der Sender-/Empfängereinheit.

Die Signalverarbeitung besteht im Wesentlichen aus der Messung der Differenzfrequenz Δf, die sich durch Mischung von Echosignal und aktueller Sendefrequenz ergibt.

Die Wahl des Parameters "Frequenzänderung" ist jedoch ein Kompromiss zwischen Reichweite, Genauigkeit und der Entfernungsauflösung des Dauerstrichradars oder FMCW-Radars und somit des Diagnosesystems.

Die berührungslos messenden Entfernungssensoren in Form von FMCW-Radarsensoren, die auf Mikrowellen basieren, sind im Vergleich zu laserbasierenden Sensoren wesentlich resistenter und weniger anfällig gegenüber Einwirkungen von Regen, Schnee, Eis und Staub. Weiterhin werden die Ergebnisse nicht durch Licht- und Schatten-Wechsel, Sonneneinstrahlung, Luftflimmern oder Wärmestrahlung beeinflusst. Dadurch kann die erfindungsgemäße Vorrichtung zur Ermittlung von Geometrie-Kennwerten bzw. deren zugehörige Sensoranordnung unter freiem Himmel bzw. auf freier Bahn-Strecke eingebaut werden. Zur Verbesserung der Messgenauigkeit ist es von Vorteil, die Radar- bzw. Mikrowellen zu bündeln, um somit auch eine allzu große Streuung bei deren Reflektion zu vermeiden. Daher sieht die Erfindung zur Bündelung der Radarwellen und damit zur Definition eines sogenannten Messfleckes eine Linse vor,

Für die Bestimmung des Verschleißzustandes eines Radprofils werden die Geometrie-Kennwerte Spurkranzhöhe Sₕ, Spurkranzbreite S_{d} und Spurkranzgradient qᵣ diagnostiziert. Die für die Berechnung dieser Kennwerte erforderlichen Ausgangswerte der Radgeometrie werden mittels Abstandsmessung zwischen Radarsensor und Radoberfläche gewonnen. Dementsprechend sind der oder die weiteren Radarsensoren auf die Lauffläche, die Hohlkehle und/oder auf die Spurkranzflanke des rollenden Rades gerichtet. Durch deren Anordnung können während der Messung pro Sensor bei abgestimmter Abtastrate zur Fahrgeschwindigkeit die Kontur an der Radoberfläche bzw. am Radprofil erfasst und ausgewertet werden.

Da die Definition der vorgenannten Geometrie-Kennwerte anhand von Bezugspunkten am Radprofil erfolgt, ist es eine Herausforderung die zugehörigen Ausgangswerte während der Überfahrt oder während des Passierens des Rades zu erfassen. Die Bezugspunkte für die Geometrie-Kennwerte sind zum einen der Radrücken, von welchem die Spurkranzbreite S_{d} gemessen wird und zum anderen die Messkreisachse, über welche die Spurkranzhöhe Sₕ und der Spurkranzgradient qᵣ bestimmt wird. Bei entsprechender Erweiterung der Sensoren kann auch der Raddurchmesser bestimmt werden. Demensprechend ist die Auswertevorrichtung der erfindungsgemäßen Vorrichtung zur Verarbeitung der Signale der Sensoren in der Form vorgesehen, dass aus den jeweils gemessenen Abständen zu den einzelnen Punkten des Radprofils die Geometrie-Kennwerte des Radprofils wie Spurkranzhöhe Sₕ, Spurkranzbreite S_{d}, Spurkranzgradient qᵣ und Raddurchmesser ermittelt werden.

Daher ist es von Vorteil, dass der erste Radarsensor auf der einen Seite der Schiene, vorzugsweise auf den Radrücken gerichtet angeordnet ist und der oder die weiteren Radarsensoren auf der anderen Seite der Schiene vorgesehen sind. Auf diese Weise kann selbst bei Sinuslauf des Schienenfahrzeugs mit Hilfe der Auswertevorrichtung und der gemessenen Entfernungen eine exakte Ermittlung der Geometrie-Kennwerte im Zehntelmillimeter-Bereich erfolgen.

Durch weitere Sensoranordnungen, die mit der ersten Sensoranordnung beidseits der Schiene eine Messstrecke bilden, kann je nach Anzahl der Anordnungen das gesamte Radprofil des rollenden Schienenfahrzeugs gemessen und analysiert werden.

Eine Ausgestaltung der Erfindung sieht zudem vor, dass zur Messung der Spurkranzhöhe ein weiterer berührungslos messender Entfernungssensor in Form eines Wirbelstromsensors vorgesehen ist. Bei Wirbelstromsensoren ist der erforderliche Abstand zur Entfernungsmessung zwischen Sensor und Zielobjekt geringer als bei Radarsensoren. Daher bietet es sich an, diesen im Bereich neben dem Schienenkopf anzuordnen. Der Geometrie-Kennwert der Spurkranzhöhe kann dann aus der ermittelten Entfernung zwischen der als Referenzfläche geeigneten Schienenoberkante und dem Spurkranz berechnet werden. Um auch hier die exakten Spurkranzhöhen zu ermitteln, ist die Unterstützung der Messung durch die Radarsensoren auf beiden Seiten der Schienen unabdingbar, da nur so wie bereits zuvor beschrieben die Bewegung des Rades senkrecht zur Schienenlängsrichtung berücksichtigt werden kann.

Die Auflösung der Abstandsmessung durch die Radarsensoren ist umso besser je größer die Bandbreite ist. Eine vorteilhafte Ausgestaltung der Erfindung sieht daher vor, dass die Radarsensoren Mikrowellen in einem Frequenzbereich von 1-300 GHz mit einer Bandbreite von 1 -4 GHz, vorzugsweise 4 GHz verwenden. Daher ist ein frequenzmoduliertes Dauerstrichradar bzw. FMCW-Radar besonders für die Laufzeitmessung zur Entfernungsbestimmung für die erfindungsgemäße Vorrichtung geeignet.

Untersuchungen der Anmelderin haben gezeigt, dass durch die Anordnung der Radarsensoren in einem Anstand von a ≥ 30 cm von dem zu messenden Rad eine genaue Vermessung des Radprofils möglich wird. Durch die Wahl der Bandbreite des Radars und/oder des Einfallwinkels der Mikrowellen wird es möglich, beim Passieren des zu vermessenden Rades mit einem Sensor einen großen Flächenbereich des Rades abzudecken. Durch mehrere Sensoranordnungen hintereinander oder in Reihe ist es außerdem möglich, eine Messstrecke zu bilden, mit der der komplette Radumfang hinsichtlich seiner Geometrie-Kennwerte oder auch der Raddurchmesser analysiert werden kann.

Mit der Erfindung wird also ein Verfahren zur Vermessung und Untersuchung des Radprofils eines rollenden Rades eines Schienenfahrzeugs unter Verwendung eines frequenzmodulierten Dauerstrichradars, der zur Abstandsmessung vorgesehen ist, bereitgestellt. Bei diesem Verfahren wird wenigstens ein Radarsensor unter einem definierten Winkel auf die zu vermessende Radfläche des rollenden Rades gerichtet, während des Rollvorgangs und der Zeit Δt wird die Radfläche ΔA vom Radar erfasst, die Abstände a zwischen Entfernungssensor und Radfläche gemessen und anschließend die Geometrie-Kennwerte für ΔA des rollenden Rades von der Auswerteelektronik berechnet.

Eine Ausgestaltung der Erfindung sieht zudem vor, dass bei dem Verfahren zur Vermessung und Untersuchung des Radprofils eines rollenden Rades eines Schienenfahrzeugs mittels eines Soll-Ist Vergleichs der Geometrie-Kennwerte des rollenden Rades der Verschleißzustand des Rades dargestellt werden kann.

Weiterhin sieht eine vorteilhafte Ausgestaltung des Verfahrens vor, dass beim Überschreiten von Grenzwerten für die Daten aus dem Soll-Ist Vergleich der Geometrie-Kennwerte des rollenden Rades eine Warnmeldung ausgegeben wird. Dies kann in Form von visuellen oder akustischen Signalen erfolgen.

Die Erfindung wird nachfolgend anhand eines Ausführungsbeispiels näher erläutert. Gleichwirkende Elemente sind dabei in der Figur mit denselben Bezugszeichen gekennzeichnet. Im Einzelnen zeigt dabei
Fig. 1 und Fig. 2 je einen Detailausschnitt eines Rades eines Schienenfahrzeugs
Fig. 3 eine perspektivische Ansicht einer Sensoranordnung einer erfindungsgemäßen Vorrichtung
Fig. 4 eine Ansicht einer Sensoranordnung gemäß Fig. 3

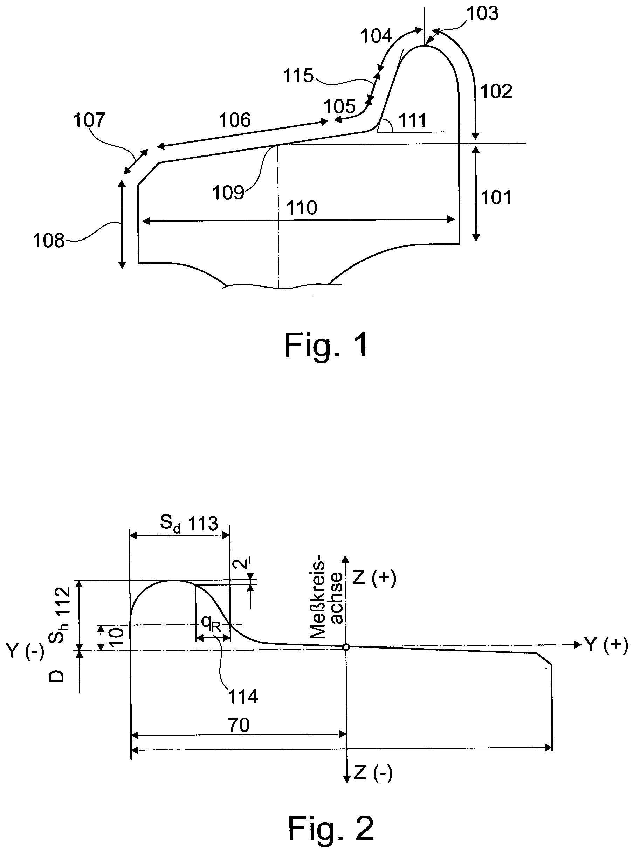

Fig. 1 und Fig. 2 zeigen jeweils einen Detailausschnitt eines Rades eines Schienenfahrzeuges und zur Erklärung die Geometrie-Kennwerte eines schienengebundenen Rades 1, wobei die Radprofilfläche in die Abschnitte innere Stirnfläche des Rades oder auch Radrücken 101, Spurkranzrückenfläche 102, Spurkranzkuppe 103, Spurkranzzehe, 104, Spurkranzflanke 115, Hohlkehle 105, Lauffläche 106, Fase 107 und Radkranzstirnfläche 108 unterteilt werden kann.

Räder von Eisenbahnfahrzeugen weisen üblicherweise einen Spurkranz in Form eines etwa drei Zentimeter hohen vertikalen Wulstes auf, der sich an der zur Mitte des Gleises gerichteten Seite der Räder befindet. An die Spurkranzkuppe 103 schließt sich eine in der Regel 70 Grad geneigte Spurkranzzehe 104 und Spurkranzflanke 115 an, bevor der Spurkranz über die Hohlkehle 105 in die Lauffläche 106 übergeht.

Der Abstand der beiden Spurkränze eines Radsatzes wird Spurmaß genannt. Die Gesamtheit der beiden Räder mit Spurkränzen, der mit ihnen fest verbundenen Radsatzwelle und gegebenenfalls den Bremsscheiben heißt Radsatz. Durch die Spurkränze wird das Spurspiel, innerhalb dessen sich das Eisenbahnfahrzeug in Querrichtung bewegen kann, jeweils durch einen Spurkranzanlauf, also das Anlaufen eines Spurkranzes an den inneren Schienenkopf (nicht dargestellt), begrenzt. Dadurch wird vor allem im unteren Geschwindigkeitsbereich eine sichere Spurführung gewährleistet.

Ein weiterer Bezugspunkt für die Radgeometrie stellt die Messkreisachse 109 dar. Diese Messkreisachse ist in einem Abstand von 70 mm vom Radrücken 101 angeordnet. Der Durchmesser des Messkreises ist daher der Raddurchmesser im Abstand von 70mm vom Radrücken 101. Demensprechend ergibt sich die Radkranzbreite 110 aus dem Abstand zwischen Radrücken 101 und Radkranzstirnfläche 108. Ohne die genannten Bezugspunkte Radrücken 101 und Messkreisachse 109 ist eine Bestimmung der Geometrie-Kennwerte Spurkranzhöhe Sₕ 112, Spurkranzbreite S_{d} 113 und Spurkranzgradient qᵣ, 114, die für die Ermittlung des Verschleißzustandes maßgeblich sind, nicht möglich. Daher ist es von großer Bedeutung, wie die Messmittel und Methoden gewählt werden, um diese Bezugspunkte zu messen. Die Ermittlung der Geometrie-Kennwerte erfolgt anschließend rechnerisch aus den gemessenen Abständen.

Die Spurkranzhöhe Sₕ 112 ergibt sich beispielsweise aus dem Abstand zwischen Lauffläche 106 unter Bezugnahme auf die Messkreisachse 109 und höchstem Punkt des Spurkranzes.

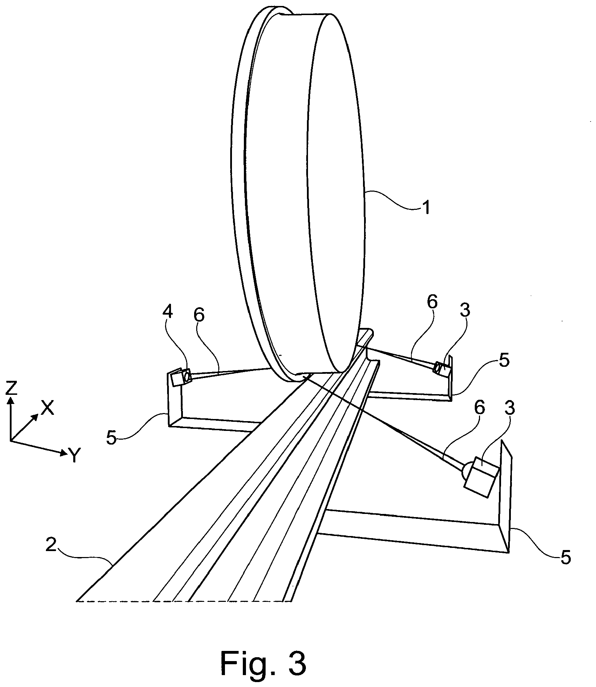

Fig. 3 zeigt in perspektivischer Darstellung eine Sensoranordnung gemäß einer erfindungsgemäßen Vorrichtung zur Ermittlung von Geometrie-Kennwerten eines Radprofils an einem rollenden Rad eines Schienenfahrzeugs. Im Bereich einer Schiene 2 sind an einer Messstrecke zwei Radarsensoren 3 mit einem Abstand a1 zur Schiene 2 und ein Radarsensor 4 mit einem Abstand a zur Schiene 2 angeordnet. Hierzu sind auf beiden Seiten der Schiene 2 Sensorhalter 5 vorgesehen, an den die Radarsensoren 3, 4 befestigt und ausgerichtet werden können. Dabei ist der Radarsensor 4 auf eine Referenzfläche eines rollenden Rades 1 während der Überfahrt gerichtet. Als Referenzfläche wird der Radrücken 101 des Rades 1 herangezogen. Die beiden weiteren Radarsensoren 3 sind auf der gegenüberliegenden Seite der Schiene 2 angeordnet und auf eine der Schiene 2 zugewandte Fläche ΔA des Rades 1 gerichtet. Hierbei ist darauf zu achten, dass der Einfallswinkel unter dem die Mikrowellen oder Radarstrahlen der Radarsensoren 3, 4 auf die entsprechende Radfläche gerichtet sind, genau definiert ist. Vorzugsweise ist der Abtaststrahl 6 eines Radarsensors 3, 4 unter einem Einfallswinkel von 0≤α≤20° auf die zu messende Fläche, vorzugsweise die Spurkranzflanke 115 gerichtet. Andernfalls werden die Messsignale zu ungenau, um eine exakte Abstandsmessung durchführen zu können. Die zu messende Oberfläche mit einem möglichst kleinen Messfleck abgetastet, um die Kontur des Radprofiles genau abtasten zu können. Das wird mit einer geeigneten Linse zur Fokussierung der Radarwellen erreicht. Bei der Überfahrt des Rades 1 können mit Hilfe eines Radarsensors 3 mehrere Punkte an der Radfläche ΔA ausgewertet werden. Über den Radarsensor 4, der auf den Radrücken 101 gerichtet ist und die entsprechenden Abstandsmessungen zwischen Radarsensor 3 und Rad 1 bzw. Radarsensoren 4 und Rad 1, können bei der Auswertung auch die Fahrteigenschaften des zugehörigen Wagens, hauptsächlich dessen Bewegung waagrecht zur Schienenlaufrichtung X, der sogenannte Sinuslauf in Y-Richtung berücksichtigt werden.

Durch die Anordnung einer Vielzahl von Radarsensoren 3, 4 in Reihe zu beiden Seiten der Schiene 2 kann dementsprechend auch ein kompletter Radumfang eines Rades bei der Überfahrt abgetastet und entsprechend hinsichtlich seines Verschleißzustandes ausgewertet werden.

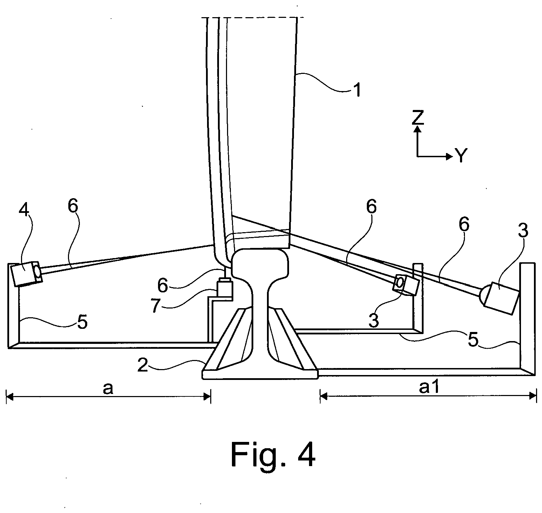

Fig. 4 zeigt eine Sensoranordnung einer erfindungsgemäßen Vorrichtung zum Ermitteln von Geometrie-Kennwerten eines Rades von vorne. Zusätzlich zu den Radarsensoren 3, 4 auf beiden Seiten der Schiene zeigt Fig. 3 einen weiteren berührungslos messenden Entfernungssensor 7, der unterhalb des Spurkranzes des Rades angeordnet ist. Da der Entfernungssensor 7 nur mit geringem Abstand zu seinen Messpunkten, der Spurkranzkuppe 103, eines vorüber rollenden Rades 1 angeordnet werden kann, ist hier ein Wirbelstromsensor 7 vorgesehen, dessen Abtastung senkrecht nach oben gerichtet ist. Da bei einem Wirbelstromsensor nur ein geringer Mindestabstand zum Messobjekt eingehalten werden muss, ist dieser für diese Entfernungsmessung besser geeignet als ein Radarsensor. Aus den Signalen des Wirbelstromsensors 7 kann somit der Abstand zwischen Wirbelstromsensor 7 und höchstem Punkt des Spurkranzes ermittelt werden. Die Spurkranzhöhe ergibt sich aus der gemessenen Entfernung zum Spurkranz und der als Referenzfläche geeigneten Schienenoberkante.

Bei der Auswertung der Abstandssignale durch die Auswertevorrichtung (nicht dargestellt) fließen die Abstandsmessungen der Radarsensoren 3, 4 mit ein, so dass gewährleistet werden kann, dass die Berechnung der Geometrie-Kennwerte jeweils unter Berücksichtigung des Spurspiels oder Sinuslaufes erfolgt ist.

Durch die erfindungsgemäße Vorrichtung wird somit eine Ermittlung des Verschließzustandes der Räder eines vorbeifahrenden Wagons oder Zuges selbst bei ungünstigen Witterungsverhältnissen und vor allem während der Fahrt möglich. Die Abtastrate kann dabei auf die Geschwindigkeit des Zuges abgestimmt werden. Daher ist beispielsweise möglich, sowohl auf Nebengleisen Radprofile an fahrenden Schienenfahrzeugen bei einer Geschwindigkeit von 20 km/h zu diagnostizieren als auch auf Hauptstrecken im High-Speed Bereich bis 200 km/h.

### Bezugszeichenliste

- 1: Rad
- 101: Radrücken
- 102: Spurkranzrückenfläche
- 103: Spurkranzkuppe
- 104: Spurkranzzehe
- 105: Hohlkehle
- 106: Lauffläche
- 107: Fase
- 108: Radkranzstirnfläche
- 109: Messkreisachse
- 110: Radkranzbreite
- 111: Flankenwinkel
- 112: Spurkranzhöhe
- 113: Spurkranzbreite
- 114: Spurkranzgradient
- 115: Spurkranzflanke
- 2: Schiene
- 3: FMCW-Radarsensor
- 4: FMCW-Radarsensor
- 5: Sensorhalter
- 6: Abtaststrahl
- 7: Wirbelstromsensor

## Patentansprüche

1. Vorrichtung zur Ermittlung von Geometrie-Kennwerten eines Radprofils an einem rollenden Rad (1) eines Schienenfahrzeugs mit
- einer ersten Sensoranordnung mit einem ersten berührungslos messenden Entfernungssensor (3), der auf eine Referenzfläche in Form der Innenplanfläche des rollenden Rades gerichtet und wenigstens einem weiteren berührungslos messenden Entfernungssensor (4), der unter einem definiertem Einfallswinkel auf die der Schiene zugewandte oder zu untersuchende Radfläche des rollenden Rades (1) gerichtet ist, wobei beide Entfernungssensoren (3), (4) mit einem definierten Abstand zur Schiene angeordnet sind,
- einer elektronischen Auswertevorrichtung zur Berechnung der Geometrie-Kennwerte aus den erfassten Abstandssignalen und
- einer Anzeigeeinheit, **dadurch gekennzeichnet, dass** der erste und der weitere berührungslos messende Entfernungssensor (3), (4) einen frequenzmodulierten Dauerstrichradar (FMCW) verwenden, wobei zur Bündelung der Radarwellen und damit zur Definition eines Messfleckes eine Linse verwendet wird.

2. Vorrichtung gemäß Anspruch 1, **dadurch gekennzeichnet, dass** der oder die weiteren Entfernungssensoren (4) in Form eines FMCW-Radarsensors auf die Lauffläche (106), die Hohlkehle (105) und/oder auf die Spurkranzflanke (104) des rollenden Rades (1) gerichtet ist.

3. Vorrichtung gemäß Anspruch 1 oder 2, **dadurch gekennzeichnet, dass** der erste Entfernungssensor(3) in Form eines FMCW-Radarsensors auf der einen Seite der Schiene (2) und der oder die weiteren FMCW-Radarsensoren (4) auf der anderen Seite der Schiene (2) vorgesehen sind.

4. Vorrichtung gemäß einem der vorhergehenden Ansprüche, **dadurch gekennzeichnet, dass** wenigstens eine weitere Sensoranordnung vorgesehen ist, die mit der ersten Sensoranordnung eine Messstrecke bildet.

5. Vorrichtung gemäß einem der vorhergehenden Ansprüche, **dadurch gekennzeichnet, dass** ein weiterer berührungslos messender Entfernungssensor als Wirbelstromsensor (7) vorgesehen ist, der auf die Spurkranzkuppe (103) gerichtet ist.

6. Vorrichtung gemäß einem der vorhergehenden Ansprüche, **dadurch gekennzeichnet, dass** die FMCW-Radarsensoren (3, 4) mit einem Frequenzbereich von 1-300 GHz vorgesehen sind.

7. Vorrichtung gemäß einem der vorhergehenden Ansprüche, **dadurch gekennzeichnet, dass** die FMCW-Radarsensoren (3, 4) mit einer Bandbreite von 1-4 GHz vorgesehen sind.

8. Vorrichtung gemäß einem der vorhergehenden Ansprüche, **dadurch gekennzeichnet, dass** die FMCW-Radarsensoren (3, 4) in einem Abstand von a, a1 ≥ 30 cm von dem zu messenden Rad (1) vorgesehen sind.

9. Verfahren zur Untersuchung des Radprofils eines rollenden Rades eines Schienenfahrzeugs unter Verwendung eines frequenzmodulierten Dauerstrichradars, der zur Abstandsmessung vorgesehen ist bei welchem wenigstens ein FMCW-Radarsensor unter einem definiertem Einfallswinkel auf die zu vermessende Radfläche des rollenden Rades gerichtet wird und während des Rollvorgangs und der Zeit Δt die Radfläche ΔA vom Radar erfasst, und die Signale der Entfernungssensoren in der Form verarbeitet wird, dass die Abstände a zwischen Entfernungssensor und Radfläche berechnet werden.

10. Verfahren gemäß Anspruch 9, **dadurch gekennzeichnet, dass** mittels der Auswertevorrichtung aus den gemessenen Abständen die Geometrie-Kennwerte des Radprofils wie Spurkranzhöhe Sₕ, Spurkranzbreite S_{d} und Spurkranzgradient qᵣ, ermittelt werden.

11. Verfahren gemäß Anspruch 10, bei dem mittels Soll-Ist Vergleichs der Geometrie-Kennwerte des rollenden Rades der Verschleißzustand des Rades ermittelt und/oder dargestellt wird.

12. Verfahren gemäß Anspruch 11, bei dem beim Überschreiten von Grenzwerten für die Daten aus dem Soll-Ist Vergleich der Geometrie-Kennwerte des rollenden Rades eine Warnmeldung ausgegeben wird.

## Claims

1. A device for determining geometry characteristic values of a wheel profile on a rolling wheel (1) of a rail vehicle, the device comprising
- a first sensor arrangement having a first non-contact measuring distance sensor (3) that is directed at a reference surface in the form of the inner planar surface of the rolling wheel and having at least one additional non-contact measuring distance sensor (4) that is directed at a defined angle of incidence at the wheel surface of the rolling wheel (1), said wheel surface facing the rail or to be examined, wherein both distance sensors (3), (4) are arranged at a defined distance from the rail,
- an electronic evaluation device for calculating the geometry characteristic values from the detected distance signals, and
- a display unit, **characterized in that** the first and additional non-contact measuring distance sensors (3), (4) utilize a frequency-modulated continuous-wave radar (FMCW), wherein a lens is used to focus the radar waves and thereby to define a measuring spot.

2. The device according to claim 1, **characterized in that** the one or additional distance sensors (4) in the form of an FMCW radar sensor are directed at the tread (106), the hollow groove (105), and/or at the wheel flange top (104) of the rolling wheel (1).

3. The device according to claim 1 or 2, **characterized in that** the first distance sensor (3) is provided in the form of an FMCW radar sensor on one side of the rail (2) and the one or additional FMCW radar sensors (4) are provided on the other side of the rail (2).

4. The device according to one of the preceding claims, **characterized in that** at least one additional sensor arrangement is provided which forms a measuring path with the first sensor arrangement.

5. The device according to one of the preceding claims, **characterized in that** an additional non-contact measuring distance sensor is provided as an eddy current sensor (7) which is directed at the wheel flange cap (103).

6. The device according to one of the preceding claims, **characterized in that** the FMCW radar sensors (3, 4) are provided with a frequency range of 1-300 GHz.

7. The device according to one of the preceding claims, **characterized in that** the FMCW radar sensors (3, 4) are provided with a bandwidth of 1-4 GHz.

8. The device according to one of the preceding claims, **characterized in that** the FMCW radar sensors (3, 4) are provided at a distance of a, a1 ≥ 30 cm from the wheel (1) to be measured.

9. A method for examining the wheel profile of a rolling wheel of a rail vehicle using a frequency-modulated continuous-wave radar, which is provided for distance measurement, in which at least one FMCW radar sensor is directed at a defined angle of incidence at the wheel surface, to be measured, of the rolling wheel and during the rolling process and the time Δt, the wheel surface ΔA is detected by the radar, and the signals of the distance sensors are processed in the form that the distances a between the distance sensor and wheel surface are calculated.

10. The method according to claim 9, **characterized in that** the geometry characteristic values of the wheel profile, such as wheel flange height Sₕ, wheel flange width S_{d}, and wheel flange gradient qᵣ, are determined from the measured distances by means of the evaluation device.

11. The method according to claim 10, wherein the state of wear of the wheel is determined and/or represented by means of a target/actual comparison of the geometry characteristic values of the rolling wheel.

12. The method according to claim 11, wherein a warning message is output when limit values for the data from the target/actual comparison of the geometry characteristic values of the rolling wheel are exceeded.

## Revendications

1. Dispositif de détermination de valeurs caractéristiques de géométrie d'un profil de roue sur une roue roulante (1) d'un véhicule ferroviaire avec
- une première disposition de capteur avec un premier capteur de distance (3) mesurant sans contact, qui est orienté vers une surface de référence sous la forme de la surface plane interne de la roue roulante et au moins un autre capteur de distance (4) mesurant sans contact, qui est orienté, avec un angle d'incidence défini par rapport à la surface de roue de la roue roulante (1) orientée vers le rail ou à examiner, les deux capteurs de distance (3, 4) étant disposés une distance définie du rail,
- un dispositif d'analyse électronique pour le calcul des valeurs caractéristiques de géométrie à partir des signaux de distance capturés et
- une unité d'affichage, **caractérisée en ce que** le premier et l'autre capteur de distance (3, 4) mesurant sans contact utilisent un radar à ondes continues (FMCW) à modulation de fréquence, moyennant quoi, pour la focalisation des ondes radar et donc pour la définition d'un point de mesure, une lentille est utilisée.

2. Dispositif selon la revendication 1, **caractérisé en ce que** le ou les autres capteurs de distance (4) sont orientés, sous la forme d'un capteur à radar FMCW vers la surface de roulement (106), la gorge (105) et/ou le flanc de boudin de roue (104) de la roue roulante (1).

3. Dispositif selon la revendication 1 ou 2, **caractérisé en ce que** le premier capteur de distance (3) conçu sous la forme d'un capteur à radar FMCW sur un côté du rail (2) ou le ou les autres capteurs à radar FMCW (4) sont disposés sur l'autre côté du rail (2).

4. Dispositif selon l'une des revendications précédentes, **caractérisé en ce qu'**au moins une autre disposition de capteur est prévue, qui forme avec la première disposition de capteur, une section de mesure.

5. Dispositif selon l'une des revendications précédentes, **caractérisé en ce qu'**un autre capteur de mesure mesurant sans contact est conçu sous la forme d'un capteur à courants de Foucault (7), qui est orienté vers l'arrondi de boudin (103).

6. Dispositif selon l'une des revendications précédentes, **caractérisé en ce que** les capteurs à radars FMCW (3, 4) sont prévus avec une plage de fréquence de 1 à 300 GHz.

7. Dispositif selon l'une des revendications précédentes, **caractérisé en ce que** les capteurs à radars FMCW (3, 4) sont prévus avec une largeur de bande de 1 à 4 GHz.

8. Dispositif selon l'une des revendications précédentes, **caractérisé en ce que** les capteurs à radars FMCW (3, 4) sont prévus à une distance de a, a1 ≥ 30 cm de la roue (1) à mesurer.

9. Procédé d'examen du profil de roue d'une roue roulante d'un véhicule ferroviaire à l'aide d'un radar à ondes continues à modulation de fréquence qui est prévu pour la mesure de distances, dans lequel au moins un capteur à radar FMCW est orienté avec un angle d'incidence défini par rapport à la surface de roue à mesurer de la roue roulante et pendant le roulement, le temps Δt et la surface de roue ΔA sont mesurés par le radar et les signaux des capteurs de distance sont traités de façon à ce que les distances a entre le capteur de distance et la surface de la roue soient calculées.

10. Procédé selon la revendication 9, **caractérisé en ce que**, au moyen du dispositif d'analyse, à partir des distances mesurées, les valeurs caractéristiques de géométrie du profil de roue comme la hauteur du boudin Sₕ, la largeur du boudin S_{d} et le gradient du boudin qᵣ, sont déterminées.

11. Procédé selon la revendication 10, dans lequel au moyen d'une comparaison consigne-réelle des valeurs caractéristiques de géométrie de la roue roulante, l'état d'usure de la roue est déterminé et/ou représenté.

12. Procédé selon la revendication 11, dans lequel, lors du dépassement de valeurs limites pour les données provenant de la comparaison consigne-réelle des valeurs caractéristiques de géométrie de la roue roulante, un message d'avertissement est généré.
